# EUROPEAN PATENT APPLICATION

(11) **EP 4 580 358 A1**
(43) Date of publication of application: **02.07.2025**
(21) Application number: 24219019.7
(22) Date of filing: 11.12.2024
(51) Int. Cl.: H10K 50/13, H10K 59/35, H10K 59/38

(54) **DISPLAY APPARATUS HAVING A WHITE LIGHT-EMITTING DEVICE**

(30) Priority: 26.12.2023 KR 20230191152
(71) Applicant: LG Display Co., Ltd., Seoul 07336 (KR)
(72) Inventor: CHOI, Hong Seok, 10845 Gyeonggi-do (KR); AHN, Byung Gun, 10845 Gyeonggi-do (KR)
(74) Representative: Ter Meer Steinmeister & Partner

(57) **Abstract**

A display apparatus including a white light-emitting device (300) is discussed. The white light-emitting device (300) can be disposed on sub-pixels of a device substrate (100). For example, the white light-emitting device (300) can overlap a red sub-pixel, a white sub-pixel, a green sub-pixel and a blue sub-pixel of the device substrate (100). Color filters (500R; 500G; 500B) can be disposed on the red sub-pixel, the green sub-pixel and the blue sub-pixel of the device substrate (100). A blue color pattern (600B) can be disposed on the white sub-pixel of the device substrate (100). The white light-emitting device (300) can be disposed on an overcoat layer (150) covering the color filters (500R; 500G; 500B) and the blue color pattern (600B). A size of the blue color pattern (600B) can be less than 40% of the total size of a white emission area (W-EA) defined in the white sub-pixel. Thus, in the display apparatus, luminance of the white color provided to a user can have a high level in high color temperature and low color temperature.

## Description

### BACKGROUND OF THE INVENTION

### Field of the Invention

The present disclosure relates to a display apparatus in which a white light-emitting device is disposed on each sub-pixel.

### Discussion of the Related Art

Generally, a display apparatus provides an image to a user. For example, the display apparatus can include at least one light-emitting device. The light-emitting device can emit light displaying a specific color.

For example, the light-emitting device can include a light-emitting unit disposed between a first electrode and a second electrode. The light-emitting unit can generate white light and can be a white light-emitting device for emitting the white light.

An image displayed to a user can consist of various colors. For example, the display apparatus can include color filters on each sub-pixel. Each of the color filters display a specific color using the light emitted from the white light-emitting device. Each of the color filters can be disposed on a path of the light emitted from the white light-emitting device. For example, the color filters can include a red color filter on a red sub-pixel, a green color filter on a green sub-pixel and a blue color filter on a blue sub-pixel, without being limited thereto. Color filters of other colors may be alternatively or additionally included.

### SUMMARY OF THE INVENTION

Accordingly, the present disclosure is directed to a display apparatus that substantially obviates one or more problems due to limitations and disadvantages of the related art.

An object of the present disclosure is to provide a display apparatus capable of minimizing differences in efficiency depending on the feeling of the color in the realized image.

Another object of the present disclosure is to provide a display apparatus in which luminance of white color has a high level in high color temperature and low color temperature.

Additional advantages, objects, and features of the disclosure will be set forth in part in the description which follows and in part will become apparent to those having ordinary skill in the art upon examination of the following or can be learned from practice of the disclosure. The objectives and other advantages of the disclosure can be realized and attained by the structure particularly pointed out in the written description and claims hereof as well as the appended drawings.

The invention is indicated in the independent claim. Further embodiments are indicated below and in the dependent claims.

To achieve these objects and other advantages and in accordance with the purpose of the present disclosure, as embodied and broadly described herein, in an aspect of the invention, there is provided a display apparatus comprising a device substrate. A blue color pattern and an over-coat layer are disposed on the device substrate. The blue color pattern is disposed on a first white emission area of the device substrate. The over-coat layer covers the blue color pattern. A white light-emitting device is disposed on the over-coat layer. The white light-emitting device overlaps the first white emission area. A size of the first white emission area overlapping with the blue color pattern is less than 40% of the total size of the first white emission area.

According to another aspect of the invention, a display apparatus comprises: a blue color pattern on a first white emission area of a device substrate; an over-coat layer on the device substrate, the over-coat layer covering the blue color pattern; and a first white light-emitting device on the over-coat layer, the first white light-emitting device overlapping with the first white emission area. The blue color pattern may overlap with a portion of the first (white) emission area. The blue color pattern may be disposed on (that is, in) a first white emission area of the device substrate. In other words, the blue color pattern may be disposed on the device substrate, in a first white emission area of the device substrate.

One or more of the herein described aspects may include one or more of the following features:
Below, features placed in brackets may comprise explanations or optional features.

The first white emission area may correspond to the first white light-emitting device. The first white light-emitting device may be disposed on the first white emission area.

In particular, the blue color pattern may overlap with only a portion of the first white emission area.

A size of the first (white) emission area overlapping with the blue color pattern may be less than about 40% of a total size of the first white emission area.

The size of the first (white) emission area overlapping with the blue color pattern may be 10% to 30% of the total size of the first white emission area.

The blue color pattern may include a first blue pattern and a second blue pattern. In embodiments, the first blue pattern may extend in a first direction. The second blue pattern can extend in a second direction. The second direction may be different from the first direction. A length of the second blue pattern in the first direction may be smaller than a length of the first white emission area in the first direction. The first blue pattern may overlap an edge of the first white emission area. In particular, the first blue pattern may overlap an edge of the first white emission area in the second direction. In other words, the first blue pattern may extend in the second direction to overlap an edge of the first white emission area. A width of the second blue pattern in the second direction may be different from a width of the first blue pattern in the second direction.

In embodiments, the blue color pattern includes a first blue pattern having a main extension in a second direction and a second blue pattern having a main extension in a (for example, first) direction different from the second direction. A length of the second blue pattern in the second direction may be smaller than a length of the first white emission area in the second direction. The first blue pattern may overlap an edge of the first white emission area in a (or: the) first direction. In other words, the first blue pattern may extend in the first direction to overlap an edge of the first white emission area. The first blue pattern may fully overlap said edge of the first white emission area. Said edge of the first white emission area may extend in the second direction. A width of the second blue pattern in the first direction may be different from a width of the first blue pattern in the first direction. The first direction may be perpendicular to the second direction. The second blue pattern may have a main extension in a direction (an inclined or diagonal direction) which is different from the second direction and different from a first direction perpendicular to the second direction.

The second blue pattern may include a same material as the first blue pattern. In particular, a material of the second blue pattern and a material of the first blue pattern may be the same.

A width of the second blue pattern may be different from a width of the first blue pattern.

The second blue pattern may be in contact with the first blue pattern within the first white emission area. In particular, the second blue pattern and the first blue pattern may form a continuous pattern within the first white emission area.

An upper surface of the over-coat layer toward the first white light-emitting device may include a concave portion and/or a convex portion. The concave portion and/or the convex portion of the upper surface may overlap (with) the first white emission area. The concave portion of the upper surface may be disposed outside (of) (that is, laterally outside, or next to, or at a different position than) the blue color pattern. Herein, laterally may refer to a plane of the device substrate. That is, the concave portion of the upper surface may be disposed non-overlapping with the blue color pattern. The convex portion of the upper surface may overlap the blue color pattern. For example, due to the concave and convex portion, a light refracted and scattered by the convex portion may be offset by (or mixed with, or at least partly counterbalanced by) a light refracted and scattered by the concave portion.

The over-coat layer and the white light-emitting device may extend on a second white emission area of the device substrate. The second white emission area may be disposed side by side with the first white emission area in the first direction. A portion of the over-coat layer overlapping with the second white emission area may have a constant thickness.

The display apparatus may further comprise a second white light-emitting device on a second white emission area of the device substrate. The over-coat layer may extend to (in particular, onto or over) the second white emission area of the device substrate and the second white light-emitting device. A portion of the over-coat layer overlapping with the second white emission area (or, in particular, the portion of the over-coat layer that overlaps with the second white emission area) may have a constant thickness.

The second white emission area may be disposed side by side with (or adjacent to) the first white emission area in a (or: the) first direction.

The second white emission area may be disposed side by side with (or adjacent to) the first white emission area in the second direction.

A light refracted and scattered by the convex portion may be offset by (or mixed with, or at least partly counterbalanced by) a light refracted and scattered by the concave portion.

In embodiments, the display apparatus may further comprise a blue color filter on a blue emission area of the device substrate. The blue color pattern may include a same material as the blue color filter. In particular, a material of the blue color pattern and a material of the blue color filter may be the same. The blue color pattern may have the same height as the blue color filter.

The blue color pattern may display (or: be configured to display) blue color using white light emitted from the first white emission area.

In embodiments, the display apparatus may further comprise a red emission area or a green emission area of the device substrate disposed to be adjacent to the first white emission area in a (or: the) first direction. The blue color pattern may include a (or: the) first blue pattern extending in a (the) second direction different from the first direction. In particular, the first blue pattern may have a main extension in the second direction. The first blue pattern may overlap an edge of the first white emission area toward the red emission area or the green emission area. That is, said edge may be an edge of the first white emission area toward or adjacent to the red emission area or the green emission area. The first blue pattern may extend in the first direction to overlap said edge of the first white emission area.

The display apparatus may comprise a first color filter on a first color emission area of the device substrate. The over-coat layer may cover the blue color pattern and the first color filter. The display apparatus may comprise a light-emitting unit on the over-coat layer, the light-emitting unit overlapping with the first white emission area and the first color emission area. The first color emission area may be disposed side by side with the first white emission area in a (the) first direction. The first color filter may overlap the entirety of the first color emission area. The blue color pattern may overlap only a portion of the first white emission area. The light-emitting unit may be a light-emitting unit of the first white light-emitting device. The light-emitting unit may further be a light-emitting unit of a first color light-emitting device overlapping with the first color emission area.

In another embodiment or aspect of the invention, there is provided a display apparatus comprising a device substrate. A blue color pattern, a first color filter and an over-coat layer are disposed on the device substrate. The blue color pattern is disposed on a white emission area of the device substrate. The first color filter is disposed on a first emission area of the device substrate. The over-coat layer covers the blue color pattern and the first color filter. A light-emitting unit is disposed on the over-coat layer. The light-emitting unit overlaps the white emission area and the first emission area. The first emission area is disposed parallel to the white emission area in a first direction. The first color filter has a large size than the first emission area. A size of the white emission area exposed by the blue color pattern is more than 60% of the total size of the first white emission area.

In another aspect of the invention, a display apparatus comprises: a blue color pattern on a white emission area of a device substrate; a first color filter on a first emission area of the device substrate; an over-coat layer on the device substrate, the over-coat layer covering the blue color pattern and the first color filter; and a light-emitting unit on the over-coat layer, the light-emitting unit overlapping with the white emission area and the first emission area. The first emission area may be disposed side by side with the white emission area in a first direction. The first color filter may overlap the entirety of the first emission area. In embodiments, the blue color pattern overlaps only a portion of the white emission area.

One or more of the herein described aspects may include, or further include, one or more of the following further features:
A size of the (first) white emission area exposed by the blue color pattern may be more than about 60% of a total size of the first white emission area.

The size of the (first) white emission area exposed by the blue color pattern may be 70% to 90% of the total size of the first white emission area.

The first (color) emission area may be disposed to be adjacent to the (first) white emission area in the first direction. The blue color pattern may include a region (in particular, a/the first blue pattern) overlapping with an edge of the (first) white emission area toward the first (color) emission area. That is, said edge may be an edge of the first white emission area toward or adjacent to the first color emission area. The region (or first blue pattern) may extend in the first direction to overlap said edge of the first white emission area.

The blue color pattern may include a (or: the) first blue pattern and a (or: the) second blue pattern. The first blue pattern may extend along an edge of the (first) white emission area. The second blue pattern may be spaced apart from the first blue pattern.

A white light (that is, a part of the white light) generated by the (first) white emission area may be emitted outside through a space between the first blue pattern and the second blue pattern.

The second blue pattern may be surrounded by a portion of the (first) white emission area exposed by the blue color pattern.

A second color filter may be disposed on a second (color) emission area of the device substrate. The second color filter may have a larger size than the second (color) emission area. The light-emitting unit may extend on (or onto, or over) the second (color) emission area. The second color emission area may be disposed side by side with the (first) white emission area and the first (color) emission area in the first direction. The second (color) emission area may be disposed parallel to the (first) white emission area and the first (color) emission area in the first direction. The second color filter may include a different material from the first color filter. In particular, a material of the second color filter and a material of the first color filter may be different. The blue color pattern may include a same material as the first color filter or the second color filter. In particular, a material of the blue color pattern and a material of the first color filter or second color filter may be the same.

The over-coat layer may include an upper surface toward the light-emitting unit. The upper surface of (the part of) the over-coat layer overlapping with the second (color) emission area may have a same shape as the upper surface of (the part of) the over-coat layer overlapping with the first (color) emission area. The upper surface of (the part of) the over-coat layer overlapping with the (first) white emission area may have a different shape from the upper surface of (the part of) the over-coat layer overlapping with the second (color) emission area.

The light-emitting unit (or a light-emitting unit of the first white light-emitting device) may include: a first emission stack including a red emission material layer, a first charge generation layer, a second emission stack including a blue emission material layer, a second charge generation layer, a third emission stack including a green emission material layer, a third charge generation layer, and a fourth emission stack including a blue emission material layer.

The light-emitting unit (or a light-emitting unit of the first white light-emitting device) may have a structure in which a first emission stack, a first charge generation layer, a second emission stack, a second charge generation layer, a third emission stack, a third charge generation layer, and a fourth emission stack are sequentially stacked. The first emission stack may include a red emission material layer. The second emission stack and the fourth emission stack may include a blue emission material layer. The third emission stack may include a green emission material layer.

A red emission area defined in a red sub-pixel, a (first) white emission area defined in a white sub-pixel, a green emission area defined in a green sub-pixel and a blue emission area defined in a blue sub-pixel can be disposed in a respective (or each) pixel area (of the device substrate). Red, green, and blue color filters respectively can be disposed on the red emission area, the green emission area and blue emission area of each pixel area. A red color filter overlapping with the red emission area, a green color filter overlapping with the green emission area and a blue color filter overlapping with the blue emission area can be disposed in each pixel area. The red color filer of each pixel area can have a larger size than the red emission area of the corresponding pixel area. The green color filer of each pixel area can have a larger size than the green emission area of the corresponding pixel area. The blue color filer of each pixel area can have a larger size than the blue emission area of the corresponding pixel area. The color filters of each pixel area can be covered by the over-coat layer.

The blue color pattern of each pixel area can be disposed on a same layer as the color filters of the corresponding pixel area. An encapsulation structure can be disposed on the first white light-emitting device. An encapsulation structure can be disposed on the light-emitting device of each sub-pixel. The blue color pattern may be disposed on an insulating layer such as a device passivation layer on the device substrate. A bank insulating layer can be disposed on the over-coat layer. The bank insulating layer can define the first white emission area. The bank insulating layer can define an emission area in each sub-pixel.

The first white light-emitting device can be disposed on sub-pixels of the device substrate. For example, the white light-emitting device can overlap a red sub-pixel, a white sub-pixel, a green sub-pixel and a blue sub-pixel of the device substrate. Color filters can be disposed on the red sub-pixel, the green sub-pixel and the blue sub-pixel of the device substrate. The blue color pattern can be disposed on the white sub-pixel of the device substrate. The first white light-emitting device can be disposed on the over-coat layer covering the color filters and the blue color pattern. A size of the blue color pattern can be less than 40% of the total size of a white emission area defined in the white sub-pixel.

### BRIEF DESCRIPTION OF THE DRAWINGS

The accompanying drawings, which are included to provide a further understanding of the present disclosure and are incorporated in and constitute a part of this application, illustrate embodiment(s) of the present disclosure and together with the description serve to explain the principle of the present disclosure. In the drawings:
FIG. 1 is a view schematically showing a display apparatus according to an embodiment of the present disclosure;
FIG. 2 is a view showing a circuit of a sub-pixel in the display apparatus according to the embodiment of the present disclosure;
FIG. 3 is an enlarged view of K1 region in FIG. 1;
FIG. 4 is a view taken along line I-I' of FIG. 3;
FIG. 5 is a view taken along line II-II' of FIG. 3;
FIG. 6 is an enlarged view of K2 region in FIG. 4; and
FIGS. 7 to 10 are views showing the display apparatus according to further embodiments of the present disclosure.

### DETAILED DESCRIPTION OF THE INVENTION

Hereinafter, details related to the above objects, technical configurations, and operational effects of the embodiments of the present disclosure will be clearly understood by the following detailed description with reference to the drawings, which illustrate some embodiments of the present disclosure. Here, the embodiments of the present disclosure are provided in order to allow the technical sprit of the present disclosure to be satisfactorily transferred to those skilled in the art, and thus the present disclosure can be embodied in other forms and is not limited to the embodiments described below.

In addition, the same or extremely similar elements can be designated by the same reference numerals throughout the specification and in the drawings, the lengths and thickness of layers and regions can be exaggerated for convenience. It will be understood that, when a first element is referred to as being "on" a second element, although the first element can be disposed on the second element so as to come into contact with the second element, a third element can be interposed between the first element and the second element.

Here, terms such as, for example, "first" and "second" can be used to distinguish any one element with another element. However, the first element and the second element can be arbitrary named according to the convenience of those skilled in the art without departing the technical sprit of the present disclosure.

The terms used in the specification of the present disclosure are merely used in order to describe particular embodiments, and are not intended to limit the scope of the present disclosure. For example, an element described in the singular form is intended to include a plurality of elements unless the context clearly indicates otherwise. In addition, in the specification of the present disclosure, it will be further understood that the terms "comprises" and "includes" specify the presence of stated features, integers, steps, operations, elements, components, and/or combinations thereof, but do not preclude the presence or addition of one or more other features, integers, steps, operations, elements, components, and/or combinations.

And, unless 'directly' is used, the terms "connected" and "coupled" can include that two components are "connected" or "coupled" through one or more other components located between the two components.

Unless otherwise defined, all terms (including technical and scientific terms) used herein have the same meaning as commonly understood by one of ordinary skill in the art to which example embodiments belong. It will be further understood that terms, such as those defined in commonly used dictionaries, should be interpreted as having a meaning that is consistent with their meaning in the context of the relevant art and should not be interpreted in an idealized or overly formal sense unless expressly so defined herein.

### (Embodiment)

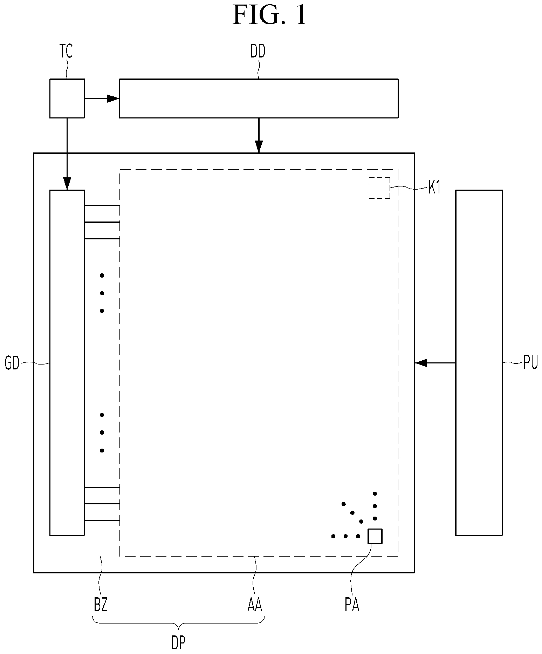

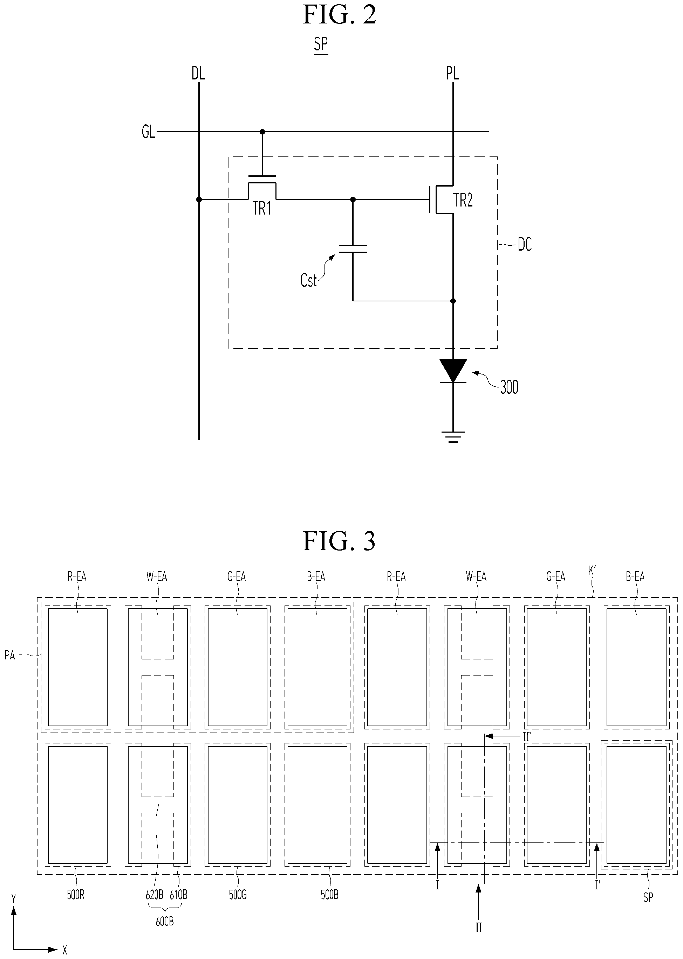

FIG. 1 is a view schematically showing a display apparatus according to an embodiment of the present disclosure. FIG. 2 is a view showing a circuit of a sub-pixel in the display apparatus according to the embodiment of the present disclosure.

Referring to FIGS. 1 and 2, the display apparatus according to the embodiment of the present disclosure can include a display panel DP. The display panel DP can generate an image provided to a user. For example, a plurality of pixel areas PA can be disposed in the display panel DP. Each of the pixel areas PA can realize a specific color. For example, each of the pixel area PA can include a plurality of sub-pixels SP. Various signals can be applied to each sub-pixel SP through signal wirings GL, DL and PL. For example, the signal wirings GL, DL and PL can include gate lines GL applying a gate signal, data lines DL applying a data signal, and power voltage supply lines PL supplying a power voltage. Embodiments are not limited thereto. As an example, one of more signal wirings, such as a sensing line, an emission controlling line etc., may be further included.

The gate lines GL can be electrically connected to a gate driver GD. The data lines DL can be electrically connected to a data driver DD. The power voltage supply lines PL can be electrically connected to a power unit PU. The gate driver GD and the data driver DD can be controlled by a timing controller TC. For example, the gate driver GD can receive clock signals, reset signals and a start signal from the timing controller TC, and the data driver DD can receive digital video data and a source timing signal from the timing controller TC. Although it is illustrated that the gate driver GD, the data driver DD and the power unit PU are respectively provided or connected at one side of the display panel DP, embodiments are not limited thereto. As an example, each of the gate driver GD, the data driver DD and the power unit PU may be provided or connected at one or more sides of the display panel DP, and/or may be provided or connected at the same side or different sides of the display panel DP.

The display panel DP can include an active area AA in which the pixel areas PA are disposed, and a bezel area BZ disposed outside the active area AA. The pixel areas PA can be disposed in a region defined by the bezel area BZ. For example, the active area AA can be partially or fully surrounded by the bezel area BZ. The gate driver GD, the data driver DD, the power unit PU and the timing controller TC can be disposed outside the active area AA. For example, each of the signal wiring GL, DL and PL can include a portion overlapping with the bezel area BZ. As an example, the bezel area BZ may be bent from the active area AA toward the rear surface of the display panel DP, without being limited thereto. As an example, the bezel area BZ may be bent from the active area AA toward the rear side of the display panel DP, such that at least a portion or an entirety of the bezel area BZ can not be seen from the front side of the display panel DP.

At least one of the gate driver GD, the data driver DD, the power unit PU and the timing controller TC can be disposed on the bezel area BZ. For example, the display apparatus according to the embodiment of the present disclosure can be a GIP (Gate In Panel) type display apparatus in which the gate driver GD is formed on the bezel area BZ.

Each of the sub-pixels SP can emit light displaying a specific color. For example, a driving circuit DC electrically connected to a light-emitting device 300 can be disposed in each sub-pixel SP. The driving circuit DC can control the light-emitting device 300 according to signals applied through the signal wirings GL, DL and PL. The driving circuit DC can be electrically connected to the signal wirings GL, DL and PL. For example, the driving circuit DC can be electrically connected to one of the gate lines GL, one of the data lines DL and one of the power voltage supply lines PL. The driving circuit DC can supply a driving current corresponding to the data signal to the light-emitting device 300 according to the gate signal for one frame. For example, the driving circuit DC can include a first thin film transistor TR1, a second thin film transistor TR2 and a storage capacitor Cst.

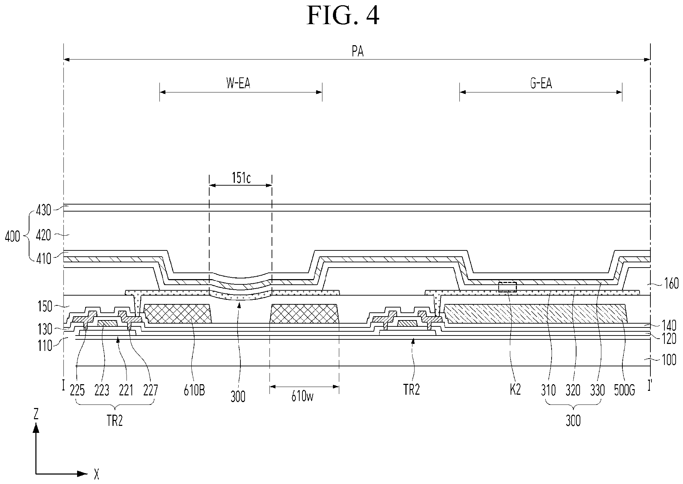

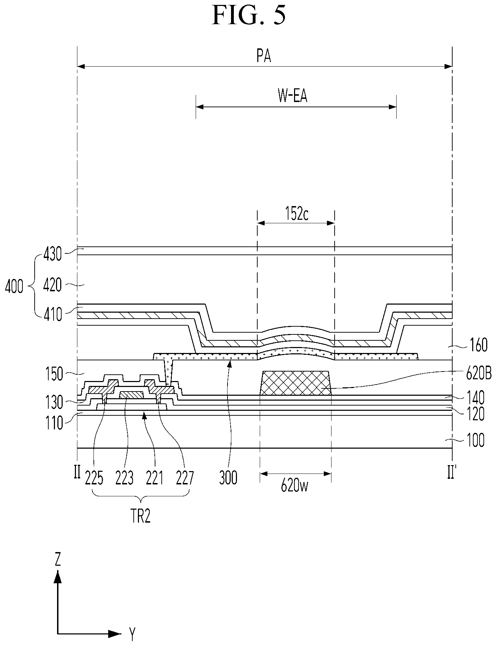

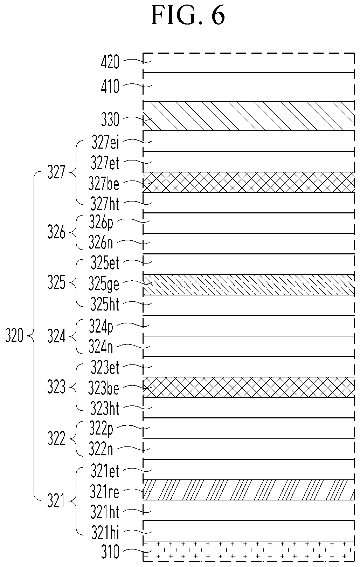

FIG. 3 is an enlarged view of K1 region in FIG. 1. FIG. 4 is a view taken along line I-I' of FIG. 3. FIG. 5 is a view taken along line II-II' of FIG. 3. FIG. 6 is an enlarged view of K2 region in FIG. 4.

Referring to FIGS. 2 to 5, the first thin film transistor TR1 can transmit the data signal to the second thin film transistor TR2 according to the gate signal. For example, the first thin film transistor TR1 can function as a switching thin film transistor. The first thin film transistor TR1 can include a first semiconductor pattern, a first gate electrode, a first drain electrode and a first source electrode. For example, the first gate electrode can be electrically connected to the gate line GL, and the first drain electrode can be electrically connected to the date line DL.

The first semiconductor pattern can include a semiconductor material. For example, the first semiconductor pattern can include amorphous silicon (a-Si), polycrystalline silicon (poly-Si), a compound semiconductor, an organic semiconductor or an oxide semiconductor, such as IGZO. The first semiconductor pattern can include a first drain region, a first channel region and a first source region. The first channel region can be disposed between the first drain region and the first source region. The first drain region and the first source region can have a smaller resistance than the first channel region. For example, the first drain region and the first source region can include a conductorized region of an oxide semiconductor. The first channel region can be a region of an oxide semiconductor, which is not or less conductorized, without being limited thereto.

The first gate electrode can be disposed on a portion of the first semiconductor pattern. For example, the first gate electrode can overlap the first channel region of the first semiconductor pattern. The first drain region and the first source region of the first semiconductor pattern can be disposed outside the first gate electrode. The first gate electrode can include a conductive material. For example, the first gate electrode can include a metal, such as aluminum (Al), chrome (Cr), copper (Cu), molybdenum (Mo), titanium (Ti) and tungsten (W), without being limited thereto. The first gate electrode can be spaced apart from the first semiconductor pattern. The first gate electrode can be insulated from the first semiconductor pattern. For example, the first drain region of the first semiconductor pattern can be electrically connected to the first source region of the first semiconductor pattern according to a signal applied to the first gate electrode.

The first drain electrode can include a conductive material. For example, the first drain electrode can include a metal, such as aluminum (Al), chrome (Cr), copper (Cu), molybdenum (Mo), titanium (Ti) and tungsten (W), without being limited thereto. The first drain electrode can include a different material from the first gate electrode. For example, the first drain electrode can be disposed on a different layer from the first gate electrode. The first drain electrode can be electrically connected to the first drain region of the first semiconductor pattern. The first drain electrode can be insulated from the first gate electrode. Embodiments are not limited thereto. As an example, the first drain electrode may include the same material as the first gate electrode, and/or may be disposed on the same layer as the first gate electrode.

The first source electrode can include a conductive material. For example, the first source electrode can include a metal, such as aluminum (Al), chrome (Cr), copper (Cu), molybdenum (Mo), titanium (Ti) and tungsten (W), without being limited thereto. The first source electrode can include a different material from the first gate electrode. The first source electrode can be disposed on a different layer from the first gate electrode. For example, the first source electrode can be disposed on a same layer as the first drain electrode. The first source electrode can include a same material as the first drain electrode. The first source electrode can be formed by a same process as the first drain electrode. For example, the first source electrode can be formed simultaneously with the first drain electrode. The first source electrode can be electrically connected to the first source region of the first semiconductor pattern. The first source electrode can be insulated from the first gate electrode. The first source electrode can be spaced apart from the first drain electrode. Embodiments are not limited thereto. As an example, the first source electrode may include the same material as the first gate electrode, and/or may be disposed on the same layer as the first gate electrode.

The second thin film transistor TR2 can generate the driving current corresponding to the data signal. For example, the second thin film transistor TR2 can function as a driving thin film transistor. The second thin film transistor TR2 can include a second semiconductor pattern 221, a second gate electrode 223, a second drain electrode 225 and a second source electrode 227. For example, the second gate electrode 223 can be electrically connected to the first source electrode of the first thin film transistor TR1, and the second drain electrode 225 can be electrically connected to the power voltage supply line PL.

The second semiconductor pattern 221 can include a semiconductor material. For example, the second semiconductor pattern 221 can include amorphous silicon (a-Si), polycrystalline silicon (poly-Si), a compound semiconductor, an organic semiconductor or an oxide semiconductor, such as IGZO. The second semiconductor pattern 221 can include a same material as the first semiconductor pattern or a different material from the first semiconductor pattern. The second semiconductor pattern 221 can be disposed on a same layer as the first semiconductor pattern, or on a different layer from the first semiconductor pattern. The second semiconductor pattern 221 can be formed by a same process as the first semiconductor pattern, without being limited thereto. For example, the second semiconductor pattern 221 can be formed simultaneously with the first semiconductor pattern, without being limited thereto.

The second semiconductor pattern 221 can include a second drain region, a second channel region and a second source region. The second channel region can be disposed between the second drain region and the second source region. The second drain region and the second source region can have a smaller resistance than the second channel region. For example, the second drain region and the second source region can include a conductorized region of an oxide semiconductor. The second channel region can be a region of an oxide semiconductor, which is not conductorized.

The second gate electrode 223 can be disposed on a portion of the second semiconductor pattern 221. For example, the second gate electrode 223 can overlap the second channel region of the second semiconductor pattern 221. The second drain region and the second source region of the second semiconductor pattern 221 can be disposed outside the second gate electrode 223. The second gate electrode 223 can include a conductive material. For example, the second gate electrode 223 can include a metal, such as aluminum (Al), chrome (Cr), copper (Cu), molybdenum (Mo), titanium (Ti) and tungsten (W), without being limited thereto. The second gate electrode 223 can be spaced apart from the second semiconductor pattern 221. The second gate electrode 223 can be insulated from the second semiconductor pattern 221. For example, the second channel region of the second semiconductor pattern 221 can have an electrical conductivity corresponding to a voltage applied to the second gate electrode 223.

The second gate electrode 223 can include a same material as the first gate electrode, or a different material from the first gate electrode. The second gate electrode 223 can be disposed on a same layer as the first gate electrode, or on a different layer from the first gate electrode. The second gate electrode 223 can be formed by a same process as the first gate electrode, without being limited thereto. For example, the second gate electrode 223 can be formed simultaneously with the first gate electrode, without being limited thereto.

The second drain electrode 225 can include a conductive material. For example, the second drain electrode 225 can include a metal, such as aluminum (Al), chrome (Cr), copper (Cu), molybdenum (Mo), titanium (Ti) and tungsten (W), without being limited thereto. The second drain electrode 225 can include a different material from the second gate electrode 223, without being limited thereto. For example, the second drain electrode 225 can be disposed on a different layer from the second gate electrode 223, without being limited thereto. The second drain electrode 225 can be electrically connected to the second drain region of the second semiconductor pattern 221. The second drain electrode 225 can be insulated from the second gate electrode 223.

The second drain electrode 225 can include a same material as the first drain electrode, or a different material from the first drain electrode. The second drain electrode 225 can be disposed on a same layer as the first drain electrode, or on a different layer from the first drain electrode. The second drain electrode 225 can be formed by a same process as the first drain electrode, without being limited thereto. For example, the second drain electrode 225 can be formed simultaneously with the first drain electrode, without being limited thereto.

The second source electrode 227 can include a conductive material. For example, the second source electrode 227 can include a metal, such as aluminum (Al), chrome (Cr), copper (Cu), molybdenum (Mo), titanium (Ti) and tungsten (W), without being limited thereto. The second source electrode 227 can include a different material from the second gate electrode 223, without being limited thereto. The second source electrode 227 can be disposed on a different layer from the second gate electrode 223, without being limited thereto. For example, the second source electrode 227 can be disposed on a same layer as the second drain electrode 225, without being limited thereto. The second source electrode 227 can include a same material as the second drain electrode 225, without being limited thereto. The second source electrode 227 can be formed by a same process as the second drain electrode 225. For example, the second source electrode 227 can be formed simultaneously with the second drain electrode 225, without being limited thereto. The second source electrode 227 can be electrically connected to the second source region of the second semiconductor pattern 221. The second source electrode 227 can be insulated from the second gate electrode 223. The second source electrode 227 can be spaced apart from the second drain electrode 225.

The storage capacitor Cst can maintain a voltage applied to the second gate electrode 223 for a period, such as one frame, without being limited thereto. For example, the storage capacitor Cst can be electrically connected to the second gate electrode 223 and the second source electrode 227. The storage capacitor Cst can have a stacked structure of capacitor electrodes. For example, the storage capacitor Cst can include a first capacitor electrode electrically connected to the second gate electrode 233, and a second capacitor electrode electrically connected to the second source electrode 227. The storage capacitor Cst can be formed by using a process of forming the first thin film transistor TR1 and the second thin film transistor TR2, without being limited thereto. For example, the first capacitor electrode can be disposed on a same layer as the second gate electrode 223, and the second capacitor electrode can be disposed on a same layer as the second source electrode 227, without being limited thereto. The first capacitor electrode can include a same material as the second gate electrode 223, and the second capacitor electrode can include a same material as the second source electrode 227, without being limited thereto. The first capacitor can be formed by a same process as the second gate electrode 223, and the second capacitor electrode can be formed by a same process as the second source electrode 227, without being limited thereto. For example, the first capacitor electrode can be formed simultaneously with the second gate electrode 223, and the second capacitor electrode can be formed simultaneously with the second source electrode 227, without being limited thereto.

The driving circuit DC and the light-emitting device 300 of each sub-pixel SP can be supported by a device substrate 100. For example, the first thin film transistor TR1, the second thin film transistor TR2 and the storage capacitor Cst of each sub-pixel SP can be disposed on the device substrate 100. The device substrate 100 can include an insulating material. For example, the device substrate 100 can include glass or plastic, without being limited thereto.

A plurality of insulating layers 110, 120, 130, 140, 150 and 160 for reducing or preventing unnecessary electrical connection can be disposed on the device substrate 100. For example, a buffer insulating layer 110, a gate insulating layer 120, an interlayer insulating layer 130, a device passivation layer 140, an over-coat layer 150 and a bank insulating layer 160 can be disposed on the device substrate 100. Embodiments are not limited thereto. As an example, at least one of the above-mentioned insulating layers may be omitted, or one or more additional insulating layers may be further included.

The buffer insulating layer 110 can be disposed close to the device substrate 100. The buffer insulating layer 110 can prevent or reduce pollution due to the device substrate 100 in a process of forming the driving circuit DC of each sub-pixel SP. For example, an upper surface of the device substrate 100 toward the driving circuit DC of each sub-pixel SP can be covered by the buffer insulating layer 110. The buffer insulating layer 110 can include an insulating material. For example, the buffer insulating layer 110 can include an inorganic insulating material, such as silicon oxide (SiOx) and silicon nitride (SiNx), without being limited thereto. The buffer insulating layer 110 can have a single-layer structure or a multi-layer structure. For example, the buffer insulating layer 110 can have a structure in which an inorganic insulating layer made of silicon oxide (SiOx) and an inorganic insulating layer made of silicon nitride (SiNx) are alternately stacked.

The gate insulating layer 120 can be disposed on the buffer insulating layer 110. The first gate electrode of each sub-pixel SP can be insulated from the first semiconductor pattern of the corresponding sub-pixel SP by the gate insulating layer 120. The second gate electrode 223 of each sub-pixel SP can be insulated from the second semiconductor pattern 221 of the corresponding sub-pixel SP by the gate insulating layer 120. For example, the gate insulating layer 120 can cover the first semiconductor pattern and the second semiconductor pattern 221 of each sub-pixel SP. The first gate electrode and the second gate electrode 223 of each sub-pixel SP can be disposed on the gate insulating layer 120. The gate insulating layer 120 can include an insulating material. For example, the gate insulating layer 120 can include an inorganic insulating material, such as silicon oxide (SiOx) and silicon nitride (SiNx).

The interlayer insulating layer 130 can be disposed on the gate insulating layer 120. The first drain electrode and the first source electrode of each sub-pixel SP can be insulated from the first gate electrode of the corresponding sub-pixel SP by the interlayer insulating layer 130, without being limited thereto. The second drain electrode 225 and the second source electrodes 227 of each sub-pixel SP can be insulated from the second gate electrode 223 of the corresponding sub-pixel SP by the interlayer insulating layer 130, without being limited thereto. For example, the interlayer insulating layer 130 can cover the first gate electrode and the second gate electrode 223 of each sub-pixel SP. The first drain electrode, the first source electrode, the second drain electrode 225 and the second source electrode 227 of each sub-pixel SP can be disposed on the interlayer insulating layer 130. The interlayer insulating layer 130 can include an insulating material. For example, the interlayer insulating layer 130 can include an inorganic insulating material.

The device passivation layer 140 can be disposed on the interlayer insulating layer 130. The device passivation layer 140 can reduce or prevent damage of the driving circuit DC in each sub-pixel SP due to external impact and moisture. For example, the first source electrode, the second drain electrode 225 and the second source electrode 227 of each sub-pixel SP can be covered by the device passivation layer 140. The first drain electrode of each sub-pixel SP can be in direct contact with the first drain region of the first semiconductor pattern in the corresponding sub-pixel SP by penetrating the gate insulating layer 120 and the interlayer insulating layer 130, and the first source electrode of each sub-pixel SP can be in direct contact with the first source region of the first semiconductor pattern in the corresponding sub-pixel SP by penetrating the gate insulating layer 120 and the interlayer insulating layer 130. The second drain electrode 225 of each sub-pixel SP can be in direct contact with the second drain region of the second semiconductor pattern 221 in the corresponding sub-pixel SP by penetrating the gate insulating layer 120 and the interlayer insulating layer 130, and the second source electrode 227 of each sub-pixel SP can be in direct contact with the second source region of the second semiconductor pattern 221 in the corresponding sub-pixel SP by penetrating the gate insulating layer 120 and the interlayer insulating layer 130. The device passivation layer 140 can include an insulating material. For example, the device passivation layer 140 can be an inorganic insulating material.

The over-coat layer 150 can be disposed on the device passivation layer 140. The over-coat layer 150 can alleviate a thickness difference due to the driving circuit DC of each sub-pixel SP. The over-coat layer 150 can include an insulating material. The over-coat layer 150 can include a different material from the device passivation layer 140, or may include the same material as the device passivation layer 140. The over-coat layer 150 can include a material having a relatively high fluidity. For example, the over-coat layer 150 can include an organic insulating material.

The light-emitting device 300 of each sub-pixel SP can be disposed on the over-coat layer 150. The light-emitting device 300 of each sub-pixel SP can emit light displaying a specific color. For example, the light-emitting device 300 of each sub-pixel SP can include a first electrode 310, a light-emitting unit 320 and a second electrode 330, which are sequentially stacked on the over-coat layer 150 of the corresponding sub-pixel SP.

The first electrode 310 can include a conductive material. The first electrode 310 can include a material having a relative high transmittance. For example, the first electrode 310 can be a transparent electrode made of a transparent conductive material, such as ITO and IZO.

The light-emitting unit 320 can generate light having luminance corresponding to a voltage difference between the first electrode 310 and the second electrode 330. For example, the light-emitting unit 320 can include an emission material layer (EML). The emission material layer can include an organic emission material, an inorganic emission material or a hybrid emission material. For example, the display apparatus according to the embodiment of the present disclosure can be an organic light-emitting display apparatus including an organic emission material.

The second electrode 330 can include a conductive material. The second electrode 330 can include a different material from the first electrode 310, or may include the same material as the first electrode 310. A reflectance of the second electrode 330 can be higher than a reflectance of the first electrode 310, without being limited thereto. For example, the second electrode 330 can include a metal, such as aluminum (Al) and silver (Ag), without being limited thereto. Thus, in the display apparatus according to the embodiment of the present disclosure, the light generated by the light-emitting unit 320 can be emitted outside through the first electrode 310 and the device substrate 100. The second electrode 330 can have a lower work function than the first electrode 310, without being limited thereto. For example, the first electrode 310 can function as an anode electrode, and the second electrode 330 can function as a cathode electrode.

The first electrode 310 of each sub-pixel SP can be electrically connected to the second thin film transistor TR2 of the corresponding sub-pixel SP. A lower surface of the first electrode 310 in each sub-pixel SP toward the device substrate 100 can be in direct contact with an upper surface of the over-coat layer 150 toward the light-emitting device 300 of each sub-pixel SP. For example, the first electrode 310 of each sub-pixel SP can be in direct contact with the second source electrode 227 of the corresponding sub-pixel SP by penetrating the device passivation layer 140 and the over-coat layer 150. Embodiments are not limited thereto. As an example, another layer may be interposed between the first electrode 310 in each sub-pixel SP and the over-coat layer 150. As an example, the first electrode 310 of each sub-pixel SP may be electrically connected with the second source electrode 227 of the corresponding sub-pixel SP via a separate electrode pattern.

The bank insulating layer 160 can be disposed on the over-coat layer 150. The bank insulating layer 160 can define an emission area R-EA, W-EA, G-EA and B-EA in each sub-pixel SP. For example, an edge of the first electrode 310 in each sub-pixel SP can be covered by the bank insulating layer 160. The light-emitting unit 320 and the second electrode 330 of each sub-pixel SP can be stacked on a portion of the corresponding first electrode 310 exposed by the bank insulating layer 160. For example, a portion of the first electrode 310 in each sub-pixel SP exposed by the bank insulating layer 160 can be an emission area R-EA, W-EA, G-EA and B-EA of the corresponding sub-pixel SP. The bank insulating layer 160 can include an insulating material, without being limited thereto. For example, the bank insulating layer 160 can be an organic insulating material. The bank insulating layer 160 can include a different material from the over-coat layer 150, or may include the same material as the over-coat layer 150. The first electrode 310 of each sub-pixel SP can be insulated from the first electrode 310 of adjacent sub-pixel SP by the bank insulating layer 160.

A voltage applied to the second electrode 330 of each sub-pixel SP can be a same as a voltage applied to the second electrode 330 of adjacent sub-pixel SP. For example, the second electrode 330 of each sub-pixel SP can be electrically connected to the second electrode 330 of adjacent sub-pixel SP. The second electrode 330 of each sub-pixel SP can include a same material as the second electrode 330 of adjacent sub-pixel SP. The second electrode 330 of each sub-pixel SP can be formed by a same process as the second electrode of adjacent sub-pixel SP. For example, the second electrode 330 of each sub-pixel SP can be formed simultaneously with the second electrode 330 of adjacent sub-pixel SP. The second electrode 330 of each sub-pixel SP can be in direct contact with the second electrode 330 of adjacent sub-pixel SP, or may be at least partially spaced apart from the second electrode 330 of adjacent sub-pixel SP. As an example, the second electrode 330 of each sub-pixel SP may be integrally formed with the second electrode 330 of adjacent sub-pixel SP. For example, the bank insulating layer 160 can overlap a portion of the second electrode 330. The second electrode 330 of each sub-pixel SP may be continuously formed on the bank insulating layer 160. Thus, in the display apparatus according to the embodiment of the present disclosure, a process of forming the second electrode 330 in each sub-pixel SP can be simplified. And, in the display apparatus according to the embodiment of the present disclosure, the luminance of the light emitted from the light-emitting device 300 of each sub-pixel SP can be adjusted by the data signal applied to the driving circuit DC of the corresponding sub-pixel SP.

The light emitted from the light-emitting device 300 of each sub-pixel SP can display a same color as the light emitted from the light-emitting device 300 of adjacent sub-pixel SP, without being limited thereto. For example, the light-emitting device 300 of each sub-pixel SP can be a white light-emitting device emitting white light. The light-emitting unit 320 of each sub-pixel SP can include a plurality of the emission material layers. For example, the light-emitting unit 320 of each sub-pixel SP can include a first emission stack 321, a first charge generation layer 322, a second emission stack 323, a second charge generation layer 324, a third emission stack 325, a third charge generation layer 326 and a fourth emission stack 327, as shown in FIG. 6, without being limited thereto.

Each of the charge generation layers 322, 324 and 326 can supply holes or electrons to adjacent emission stack 321, 323, 325 and 327. For example, each of the charge generation layers 322, 324 and 326 can have a stacked structure of an n-type charge generating layer 322n, 324n and 326n and a p-type charge generating layer 322p, 324p and 326p. Each of the first emission stack 321 and the second emission stack 323 can emit light. The n-type charge generating layer 322n, 324n and 326n of each charge generation layer 322, 324 and 326 can supply electrons to adjacent emission stack 321, 323, 325 and 327, the p-type charge generating layer 322p, 324p and 326p of each charge generation layer 322, 324 and 326 can supply holes to adjacent emission stack 321, 323, 325 and 327. For example, the first emission stack 321 can be disposed between the first electrode 310 and the n-type charge generating layer 322n of the first charge generation layer 322, and the fourth emission stack 327 can be disposed between the p-type charge generating layer 326p of the third charge generation layer 326 and the second electrode 330. The second emission stack 323 can be disposed between the p-type charge generating layer 322p of the first charge generation layer 322 and the n-type charge generating layer 324n of the second charge generation layer 324, and the third emission stack 325 can be disposed between the p-type charge generating layer 324p of the second charge generation layer 324 and the n-type charge generating layer 326n of the third chare generation layer 326. Thus, in the display apparatus according to the embodiment of the present disclosure, each of the emission stacks 321, 323, 325 and 327 can generate and emit light.

Light emitted from at least one of the emission stacks 321, 323, 325 and 327 can display a different color from light emitted from adjacent emission stack 321, 323, 325 and 327. For example, the first emission stack 321 can include a hole injection layer 321hi, a first hole transport layer 321ht, a red emission material layer 321re and a first electron transport layer 321et, which are sequentially stacked, the second emission stack 323 can include a second hole transport layer 323ht, a first blue emission material layer 323be and a second electron transport layer 323et, which are sequentially stacked, and the third emission stack 325 can include a third hole transport layer 325ht, a green emission material layer 325ge and a third electron transport layer 325et, which are sequentially stacked. Light emitted from the fourth emission stack 327 can display a same color as light emitted from the second emissions tack 323, without being limited thereto. For example, the fourth emission stack 327 can include a fourth hole transport layer 327ht, a second blue emission material layer 327be, a fourth electron transport layer 327et and an electron injection layer 327ei, which are sequentially stacked. The second blue emission material layer 327be can include a same material as the first blue emission material layer 323be, or may include a different material from the first blue emission material layer 323be. For example, the light emitted from the fourth emission stack 327 can have a same wave-length range as the light emitted from the second emission stack 323, or a different wave-length range from the light emitted from the second emission stack 323. Thus, in the display apparatus according to the embodiment of the present disclosure, luminance of the light emitted from the emission area R-EA, W-EA, G-EA and B-EA of each sub-pixel SP can be increased or maximized. And, in the display apparatus according to the embodiment of the present disclosure, efficiency of the light-emitting device 300 in each sub-pixel SP can be increased or maximized. Therefore, in the display apparatus according to the embodiment of the present disclosure, power consumption can be reduced. Embodiments are not limited thereto. As an example, at least one of the emission stacks 321, 323, 325 and 327 may be omitted. As an example, at least one of the hole injection layer, the hole transport layer, the electron transport layer, electron injection layer of at least one of the emission stacks 321, 323, 325 and 327 may be omitted.

The light-emitting unit 320 of each sub-pixel SP can have a stacked structure same as the light-emitting unit 320 of adjacent sub-pixel SP, without being limited thereto. The light-emitting unit 320 of each sub-pixel SP can be formed by a same process as the light-emitting unit 320 of adjacent sub-pixel SP, without being limited thereto. For example, the light-emitting unit 320 of each sub-pixel SP can be formed simultaneously with the light-emitting unit 320 of adjacent sub-pixel SP, without being limited thereto. The light-emitting unit 320 of each sub-pixel SP can be in direct contact with the light-emitting unit 320 of adjacent sub-pixel SP. For example, the light-emitting unit 320 of each pixel area PA can be recognized as continuous on the sub-pixels SP of the corresponding pixel area PA, as shown in FIGS. 3 to 5. Thus, in the display apparatus according to the embodiment of the present disclosure, process efficiency can be improved. Embodiments are not limited thereto. As an example, the light-emitting unit 320 of each pixel area PA may be at least partially separated from each other. As an example, the light-emitting unit 320 of each pixel area PA may be separated patterned for each pixel area PA, without being limited thereto.

Light emitted from the emission area of each sub-pixel SP in each pixel area PA can display a different color from light emitted from the emission area of an adjacent sub-pixel SP in the corresponding pixel area PA, without being limited thereto. For example, a red emission area R-EA defined in a red sub-pixel, a white emission area W-EA defined in a white sub-pixel, a green emission area G-EA defined in a green sub-pixel and a blue emission area B-EA defined in a blue sub-pixel can be disposed in each pixel area PA. The pixel areas PA can be disposed side by side in a first direction X and a second direction Y perpendicular to the first direction X. For example, the arrangement of the pixel areas PA can have a matrix shape. The sub-pixels SP of each pixel area PA can be disposed side by side in the first direction X, may be disposed side by side in the second direction Y, or may be disposed to have a matrix shape. For example, the red emission area R-EA, the white emission area W-EA, the green emission area G-EA and the blue emission area B-EA of each pixel area PA can be disposed side by side in the first direction X, may be disposed side by side in the second direction Y, or may be disposed to have a matrix shape. The sub-pixels SP of each pixel area PA can be arranged in the same order, or may be arranged in different order. For example, the light emitted from an emission area can display a same color as the light emitted from the emission area adjacent in the second direction Y, or may display a different color from the light emitted from the emission area adjacent in the second direction Y.

Color filters 500R, 500G and 500B can be disposed on the red emission area R-EA, the green emission area G-EA and blue emission area B-EA of each pixel area PA. Each of the color filters 500R, 500G and 500B can display a specific color using white light generated by the light-emitting unit 320 of the pixel area PA. For example, a red color filter 500R overlapping with the red emission area R-EA, a green color filter 500G overlapping with the green emission area G-EA and a blue color filter 500B overlapping with the blue emission area B-EA can be disposed in each pixel area PA. The color filters 500R, 500G and 500B of each pixel area PA can be disposed on a path of the light emitted from the light-emitting device 300 of the corresponding pixel area PA. For example, the color filters 500R, 500G and 500B of each pixel area PA can be disposed between the device passivation layer 140 and the over-coat layer 150 of the corresponding pixel area PA, without being limited thereto. A thickness difference due to the color filters 500R, 500G and 500B of each pixel area PA can be alleviated by the over-coat layer 150.

The red color filer 500R of each pixel area PA can have a larger size than the red emission area R-EA of the corresponding pixel area PA. The green color filer 500G of each pixel area PA can have a larger size than the green emission area G-EA of the corresponding pixel area PA. The blue color filer 500B of each pixel area PA can have a larger size than the blue emission area B-EA of the corresponding pixel area PA. Thus, in the display apparatus according to the embodiment of the present disclosure, the light emitted from the red emission area R-EA, the green emission area G-EA and the blue emission area B-EA of each pixel area PA must pass through the corresponding color filters 500R, 500G and 500B, respectively. Therefore, in the display apparatus according to the embodiment of the present disclosure, light leakage and color mixing that occur as the light emitted from the red emission area R-EA, the green emission area G-EA and the blue emission area B-EA of each pixel area PA is emitted without passing through the corresponding color filter 500R, 500G and 500B can be reduced or prevented. That is, in the display apparatus according to the embodiment of the present disclosure, quality of image provided to the user can be improved.

The color filters 500R, 500G and 500B of each pixel area PA can be covered by the over-coat layer 150. Thus, in the display apparatus according to the embodiment of the present disclosure, an upper surface of a portion of the over-coat layer 150 overlapping with the red emission area R-EA, an upper surface of a portion of the over-coat layer 150 overlapping with the green emission area G-EA and an upper surface of a portion of the over-coat layer 150 overlapping with the blue emission area B-EA in each pixel area PA can have a constant level, respectively. For example, in the display apparatus according to the embodiment of the present disclosure, the upper surface of a portion of the over-coat layer 150 overlapping with each red emission area R-EA can have a same level as the upper surface of a portion of the over-coat layer 150 overlapping with each green emission area G-EA and the upper surface of a portion of the over-coat layer 150 overlapping with each blue emission area B-EA. That is, in the display apparatus according to the embodiment of the present disclosure, the upper surface of a portion of the over-coat layer 150 overlapping with each red emission area R-EA, the upper surface of a portion of the over-coat layer 150 overlapping with each green emission area G-EA and the upper surface of a portion of the over-coat layer 150 overlapping with each blue emission area B-EA can be parallel to the upper surface of the device substrate 100. Therefore, in the display apparatus according to the embodiment of the present disclosure, luminance deviation due to the generating location of the light emitted from the red emission area R-EA, the green emission area G-EA and the blue emission area B-EA of each pixel area PA can be reduced or prevented.

A blue color pattern 600B can be disposed within the white emission area W-EA of each pixel area PA. The blue color pattern 600B can display blue color using whit light emitted from the white emission area W-EA of each pixel area PA. The blue color pattern 600B of each pixel area PA can be disposed on a same layer as the color filters 500R, 500G and 500B of the corresponding pixel area PA. For example, the blue color pattern 600B of each pixel area PA can be disposed between the device passivation layer 140 and the over-coat layer 150 of the corresponding pixel area PA. The blue color pattern 600B can include a same material as the blue color filter 500B. The blue color pattern 600B can be formed by a same process as the blue color filter 500B. For example, the blue color pattern 600B can be formed simultaneously with the blue color filter 500B. For example, the blue color pattern 600B may have the same height as the blue color filter 500B. The blue color pattern 600B of each pixel area PA can be covered by the over-coat layer 150. For example, a thickness difference due to the blue color pattern 600B of each pixel area PA can be alleviated by the over-coat layer 150.

The blue color pattern 600B of each pixel area PA can include a portion overlapping with the white emission area W-EA of the corresponding pixel area PA. The blue color pattern 600B of each pixel area PA may overlap a portion of the white emission area W-EA of the corresponding pixel area PA. As an example, the white emission area W-EA of the corresponding pixel area PA may overlap a portion of the blue color pattern 600B of each pixel area PA. The blue color pattern 600B of each pixel area PA can have a smaller size than the white emission area W-EA of the corresponding pixel area PA, without being limited thereto. The blue color pattern 600B of each pixel area PA may have a size equal to or greater than that of the white emission area W-EA of the corresponding pixel area PA. That is, in the display apparatus according to the embodiment of the present disclosure, efficiency of white color provided to the user can be improved by white light emitted from the white emission area W-EA of each pixel area PA, and luminance according to color temperature of white color provided to the user can be adjusted by the blue color pattern 600B of the corresponding pixel area PA.

Table 1 below shows examples of the luminance of white color provided to a user in high color temperature and low color temperature according to a size of the blue color pattern 600B in the white emission area W-EA. Here, comparative example 1 is a display apparatus including a same pixel areas PA as the display apparatus according to the embodiment of the present disclosure, wherein efficiency of each pixel area PA is reduced without forming the blue color pattern 600B. Comparative examples 2 and 3 and experimental examples 1 to 3 include the blue color pattern 600B having different sizes in the display apparatus according to the embodiment of the present disclosure. And, the size of the blue color pattern 600B in Table 1 means the ratio of the size occupied by the blue color pattern 600B based on the total size of the white emission area W-EA.

**[Table 1]**

| | Relative efficiency | | | Size of the blue color pattern | Luminance in high color temperature (nit) | Luminance in low color temperature (nit) |
|---|---|---|---|---|---|---|
| | R-EA | G-EA | B-EA | | | |
| Comparative example 1 | 79% | 85% | 96% | 0% | 300 | 221 |
| Comparative example 2 | 100% | 100% | 100% | 0% | 285 | 391 |
| Experimental example 1 | 100% | 100% | 100% | 10% | 289 | 391 |
| Experimental example 2 | 100% | 100% | 100% | 20% | 293 | 391 |
| Experimental example 3 | 100% | 100% | 100% | 30% | 298 | 391 |
| Comparative example 3 | 100% | 100% | 100% | 40% | 281 | 391 |

Referring to Table 1 above, if the efficiency of each pixel area PA is reduced without forming the blue color pattern 600B, the white color provided to the user can have high luminance in high color temperature, but the white color provided to the user can have significantly low luminance in low color temperature. On the other hand, if the blue color pattern 600B having a size of less than 40% of the total size of the white emission area W-EA is disposed in the white emission area W-EA, luminance of the white color provided to the user can have a high level in high color temperature and low color temperatures. Further, if the blue color pattern 600B having a size of 10% to 30% of the total size of the white emission area W-EA is disposed in the white emission area W-EA, the white color provided to the user in high color temperature can have luminance of a similar level to the display apparatus in which efficiency of each pixel area PA is reduced. That is, in the display apparatus according to the embodiment of the present disclosure, the blue color pattern 600B can be disposed within the white emission area W-EA of each pixel area PA, and a size of the white emission area W-EA overlapping with the blue color pattern 600B can be less than 40% of the total size of the white emission area W-EA, preferably 10% to 30% of the total size of the white emission area W-EA. Thus, in the display apparatus according to the embodiment of the present disclosure, the white color provided to the user can have high luminance in high color temperature and low color temperature without deterioration of efficiency of each pixel area PA. Therefore, in the display apparatus according to the embodiment of the present disclosure, differences in quality of the image provided to the user according to the feeling of the color can be reduced or minimized. And, in the display apparatus according to the embodiment of the present disclosure, differences in efficiency according to the feeling of the color in the realized image can be reduced or minimized.

An encapsulation structure 400 can be disposed on the light-emitting device 300 of each sub-pixel SP. The encapsulation structure 400 can reduce or prevent damage of the light-emitting devices 300 due to external moisture and impact. The encapsulation structure 400 can have a multi-layer structure. For example, the encapsulation structure 400 can include a first encapsulating layer 410, a second encapsulating layer 420 and a third encapsulating layer 430, which are sequentially stacked. The first encapsulating layer 410, the second encapsulating layer 420 and the third encapsulating layer 430 can include an insulating material. The second encapsulating layer 420 can include a different material from the first encapsulating layer 410 and the third encapsulating layer 430. For example, the first encapsulating layer 410 and the third encapsulating layer 430 can be an inorganic encapsulating layer including an inorganic insulating material, and the second encapsulating layer 420 can be an organic encapsulating layer including an organic insulating material. A thickness difference due to the light-emitting device 300 of each sub-pixel SP can be alleviated by the second encapsulating layer 420. For example, an upper surface of the encapsulation structure 400 opposite to the device substrate 100 can be parallel to the upper surface of the device substrate 100. Thus, in the display apparatus according to the embodiment of the present disclosure, the damage of the light-emitting device 300 in each sub-pixel SP due to the external moisture and impact can be effectively reduced or prevented.

Accordingly, the display apparatus according to the embodiment of the present disclosure can include the blue color pattern 600B on the white emission area W-EA of each pixel area PA and in the light-emitting device 300 overlapping with the blue color pattern 600B, wherein the light-emitting unit 320 of the light-emitting device 300 can generate and emit white light, more than 60% of the total size of the white emission area W-EA, preferably 70% to 90% of the total size of the white emission area W-EA, can be exposed by the blue color pattern 600B.

Thus, in the display apparatus according to the embodiment of the present disclosure, luminance of the white color provided to the user can have high level in high color temperature and low color temperature, without deterioration of efficiency of each pixel area PA. Therefore, in the display apparatus according to the embodiment of the present disclosure, differences in quality of the image provided to the user according to the feeling of the color can be reduced or minimized. And, in the display apparatus according to the embodiment of the present disclosure, differences in efficiency of each pixel area PA according to the feeling of the color can be reduced or minimized.

In the display apparatus according to the embodiment of the present disclosure, the blue color pattern 600B of each pixel area PA can include a first blue pattern 610B and a second blue pattern 620B. A plane shape of the second blue pattern 620B can be different from a plane shape of the first blue pattern 610B, without being limited thereto. For example, the first blue pattern 610B can extend in the second direction Y, and the second blue pattern 620B can extend in the first direction X, without being limited thereto.

The first blue pattern 610B of each pixel area PA can overlap an edge of the corresponding white emission area W-EA toward adjacent sub-pixel SP. For example, a side of the white emission area W-EA toward the red emission area R-EA and a side of the white emission area W-EA toward the green emission area G-EA within each pixel area PA can overlap the first blue pattern 610B of the corresponding pixel area PA. Thus, in the display apparatus according to the embodiment of the present disclosure, the emission of the white light emitted from emission areas adjacent to the white emission area W-EA in each pixel area PA, for example the red emission area R-EA and the green emission area G-EA without passing through the color filters 500R, 500G and 500B of the corresponding pixel area PA can be reduced or prevented. Therefore, in the display apparatus according to the embodiment of the present disclosure, light leakage and color mixing can be reduced or prevented. And, in the display apparatus according to the embodiment of the present disclosure, quality of the image can be improved. Although it is illustrated and described that the red emission area R-EA and the green emission area G-EA are emission areas adjacent to the white emission area W-EA in each pixel area PA, embodiments are not limited thereto. As an example, the emission areas adjacent to the white emission area W-EA in each pixel area PA may alternatively include the blue emission area B-EA.

The second blue pattern 620B of each pixel area PA can be disposed within the white emission area W-EA of the corresponding pixel area PA. For example, the second blue pattern 620B of each pixel area PA can be disposed on a central portion of the white emission area W-EA in the corresponding pixel area PA. The second blue pattern 620B of each pixel area PA can be in contact with the first blue pattern 610B of the corresponding pixel area PA within the white emission area W-EA of the corresponding pixel area PA. The second blue pattern 620B of each pixel area PA can include a same material as the first blue pattern 610B of the corresponding pixel area PA. The second blue pattern 620B of each pixel area PA can be formed by a same process as the first blue pattern 610B of the corresponding pixel area PA. For example, the second blue pattern 620B of each pixel area PA can be formed simultaneously with the first blue pattern 610B of the corresponding pixel area PA. A width of the second blue pattern 620B in each pixel area PA can be different from or the same as a width of the first blue pattern 610B in the corresponding pixel area PA. As an example, the second blue pattern 620B of each pixel area PA may be spaced apart from the first blue pattern 610B of the corresponding pixel area PA within the white emission area W-EA of the corresponding pixel area PA.

The upper surface of a portion of the over-coat layer 150 overlapping with the white emission area W-EA of each pixel area PA can include a concave portion 151c and/or a convex portion 152c due to the blue color pattern 600B of each pixel area PA. For example, the concave portion 151c of the upper surface of the over-coat layer 150 can be disposed outside the blue color pattern 600B in each white emission area W-EA, and the convex portion 152c of the upper surface of the over-coat layer 150 can overlap the second blue pattern 620B in each white emission area W-EA. That is, in the display apparatus according to the embodiment of the present disclosure, the light emitted from each white emission area W-EA can be refracted and scattered by the concave portion 151c and the convex portion 152c of the upper surface of the over-coat layer 150 in the corresponding white emission area PA. The light refracted and scattered by the convex portion 152c of the upper surface of the over-coat layer 150 in each white emission area W-EA can be at least partially offset by the light refracted and scattered by the concave portion 151c of the upper surface of the over-coat layer 150 in each white emission area W-EA. Thus, in the display apparatus according to the embodiment of the present disclosure, deterioration in efficiency due to the blue color pattern 600B of each white emission area W-EA can be reduced of prevented. Therefore, in the display apparatus according to the embodiment of the present disclosure, the white color provided to the user can have high luminance in high color temperature and low color temperature, without deterioration in efficiency of each pixel area PA.

The display apparatus according to the embodiment of the present disclosure is described that the driving circuit DC of each sub-pixel SP can consist of the first thin film transistor TR1, the second thin film transistor TR2 and the storage capacitor Cst. However, in the display apparatus according to another embodiment of the present disclosure, the driving circuit DC of each sub-pixel SP can include a driving thin film transistor and at least one switching thin film transistor. For example, in the display apparatus according to another embodiment of the present disclosure, the driving circuit DC of each sub-pixel SP can further include a third thin film transistor for initializing the storage capacitor Cst of the corresponding sub-pixel SP according to the gate signal. The third thin film transistor of each sub-pixel SP can include a third semiconductor pattern, a third gate electrode, a third drain electrode and a third source electrode. The third semiconductor pattern of each sub-pixel SP can include a semiconductor material. The third gate electrode of each sub-pixel SP can be electrically connected to the gate line GL. The third drain electrode of each sub-pixel SP can be electrically connected to an initial line applying an initial signal. The third source electrode of each sub-pixel SP can be electrically connected to the storage capacitor Cst of the corresponding sub-pixel SP. Thus, in the display apparatus according to another embodiment of the present disclosure, the degree of freedom in configuration of each driving circuit DC can be improved.

In the display apparatus according to the embodiment of the present disclosure, the location and the electric connection of the first drain electrode, the first source electrode, the second drain electrodes 225 and the second source electrode 227 in each driving circuit DC can vary depending on the configuration of the corresponding driving circuit DC and/or the type of the corresponding thin film transistors TR1 and TR2. For example, in the display apparatus according to another embodiment of the present disclosure, the second gate electrode 223 of each driving circuit DC can be electrically connected to the first drain electrode of the corresponding driving circuit DC. Thus, in the display apparatus according to another embodiment of the present disclosure, the degree of freedom in the configuration of each driving circuit DC and the type of each thin film transistor TR1 and TR2 can be improved.

The display apparatus according to the embodiment of the present disclosure is described that the second blue pattern 620B of each white emission area W-EA can extend in the first direction X. However, in the display apparatus according to another embodiment of the present disclosure, the second blue pattern 620B of each white emission area W-EA can extend in various directions.

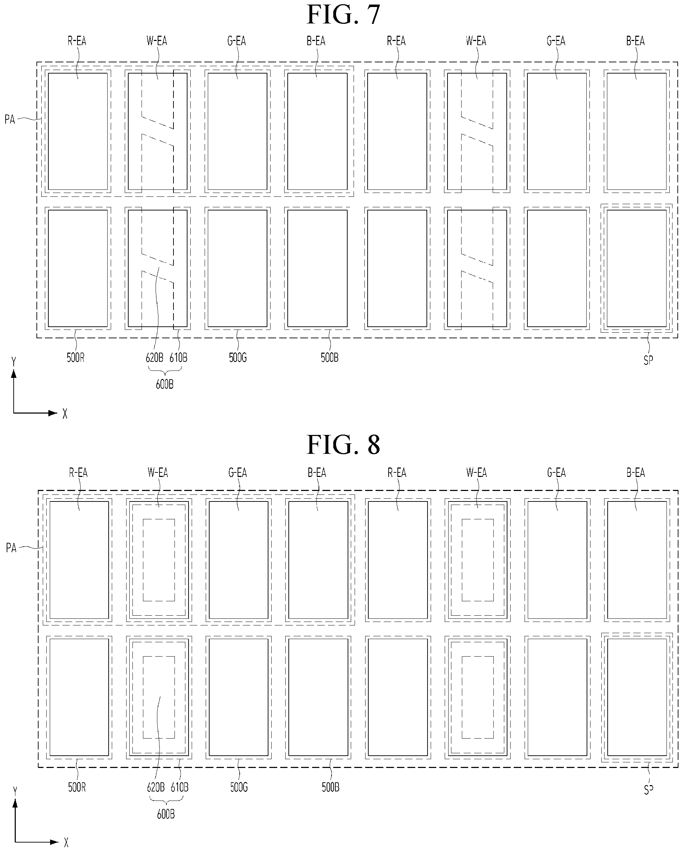

FIGS. 7 to 10 are views showing the display apparatus according to another embodiment of the present disclosure.

For example, in the display apparatus according to another embodiment of the present disclosure, the second blue pattern 620B of each white emission area W-EA can extend in a diagonal direction inclined in the first direction X and the second direction Y, as shown in FIG. 7. Thus, in the display apparatus according to another embodiment of the present disclosure, the light refracted and scattered by the convex portion 152c of the upper surface of the over-coat layer 150 on each white emission area W-EA can be effectively offset by the light refracted and scattered by the concave portion 151c of the upper surface of the over-coat layer 150 on each white emission area W-EA.

The display apparatus according to the embodiment of the present disclosure is described that the first blue pattern 610B of each white emission area W-EA can extend in the second direction Y. However, in the display apparatus according to another embodiment of the present disclosure, a plane of the first blue pattern 610B in each white emission area W-EA can have various shapes. For example, in the display apparatus according to another embodiment of the present disclosure, the first blue pattern 610B on each white emission area w-EA can extend along an edge of the corresponding white emission area W-EA, as shown in FIG. 8. All sides of each white emission area W-EA can overlap the first blue pattern 610B on the corresponding white emission area W-EA. For example, a plane of the first blue pattern 610B on each white emission area W-EA can have a closed loop shape. Thus, in the display apparatus according to another embodiment of the present disclosure, light leakage and color mixing due to the white emission area W-EA of each pixel area PA can be effectively reduced or prevented. Embodiments are not limited thereto. As an example, at least one side of each white emission area W-EA may not overlap the first blue pattern 610B on the corresponding white emission area W-EA.

In the display apparatus according to another embodiment of the present disclosure, the second blue pattern 620B in each white emission area W-EA can be spaced apart from the first blue pattern 610B in the corresponding white emission area W-EA. For example, a plane of the second blue pattern 620B in each white emission area W-EA can have a bar shape extending the second direction Y, the first direction X, or any other directions, or any other shapes, the first blue pattern 610B in each white emission area W-EA can extend along an edge of the corresponding white emission area W-EA, and the white light generated by each white emission area W-EA can be emitted outside through a space between the first blue pattern 610B and the second blue pattern 620B of the corresponding white emission area W-EA. For example, the second blue pattern 620B in each white emission area W-EA can be surrounded by a portion exposed by the blue color pattern 600B of the corresponding white emission area W-EA. Thus, in the display apparatus according to another embodiment of the present disclosure, the degree of freedom for the configuration of the blue color pattern 600B in each white emission area W-EA can be improved.

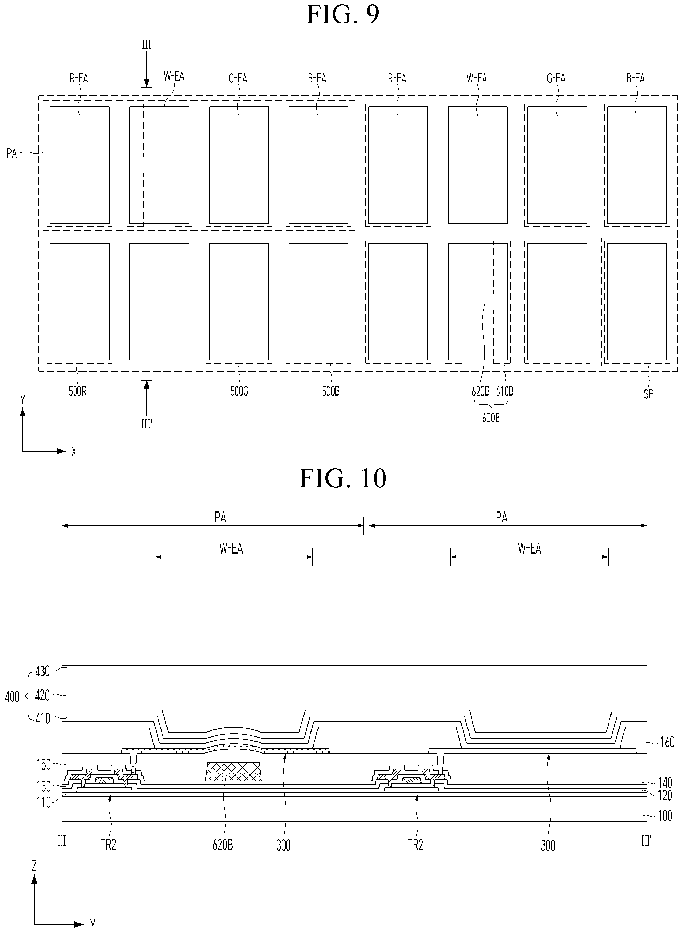

The display apparatus according to the embodiment of the present disclosure is described that the blue color pattern 600B can be disposed on the white emission area W-EA of each pixel area PA. However, in the display apparatus according to another embodiment of the present disclosure, the blue color pattern 600B can be disposed on the white emission area W-EA of some of the pixel areas PA. For example, in the display apparatus according to another embodiment of the present disclosure, the blue color pattern 600B can be disposed on the white emission area W-EA of only one of two pixel areas PA adjacent in the first direction X or the second direction Y, as shown in FIGS. 9 and 10. The over-coat layer 150 on the white emission area W-EA of one of two pixel areas PA adjacent in the first direction X or the second direction Y can have a constant thickness. Thus, in the display apparatus according to another embodiment of the present disclosure, the luminance of the white color provided to the user can be adjusted by the white emission areas W-EA of two pixel areas PA adjacent in the first direction X or the second direction Y. That is, in the display apparatus according to another embodiment of the present disclosure, differences in luminance of the white color due to the feeling of the color in the image can be reduced or minimized. Therefore, in the display apparatus according to another embodiment of the present disclosure, differences in quality of the image provided to the user due to the feeling of the realized color can be effectively reduced or minimized. Embodiments are not limited thereto. As an example, the blue color pattern 600B may be disposed in various shapes within the white emission area W-EA of each pixel area PA or some of the pixel areas PA, as long as it doesn't occupy the entirety of the white emission area W-EA. As an example, the blue color pattern 600B of the white emission area W-EA of each pixel area PA may comprises single blue pattern or more than two blue patterns connected to each other or separated from each other. As an example, the blue color pattern 600B of the white emission areas W-EA of different pixel areas PA may have the same or different shapes or sizes.

In the result, the display apparatus according to the embodiments of the present disclosure can comprise the over-coat layer on the emission areas of the device substrate and the white light-emitting device on the over-coat layer, wherein the emission areas can include the white emission area overlapping with the white light-emitting device, wherein the blue color pattern can be disposed between the white emission area of the device substrate and the over-coat layer, and wherein the size of the blue color pattern can be less than 40% of the total size of the white emission area. Thus, in the display apparatus according to the embodiments of the present disclosure, the luminance of the white color provided to the user can have the high level in the high color temperature and the low color temperature.

Thereby, in the display apparatus according to the embodiments of the present disclosure, the differences in the quality of the image provided to the user due to the feeling of the color can be reduced or minimized. And, in the display apparatus according to the embodiments of the present disclosure, the difference in the efficiency due to the feeling of the color in the realized image can be reduced or minimized, and power consumption can be reduced by low power driving.

## Claims

1. A display apparatus comprising:
a blue color pattern (600B) on a first white emission area (W-EA) of a device substrate (100);
an over-coat layer (150) on the device substrate (100), the over-coat layer (150) covering the blue color pattern (600B); and
a first white light-emitting device (300) on the over-coat layer (150), the first white light-emitting device (300) overlapping with the first white emission area (W-EA),
wherein the blue color pattern (600B) overlaps with a portion of the first white emission area (W-EA).

2. The display apparatus according to claim 1, wherein a size of the first white emission area (W-EA) overlapping with the blue color pattern (600B) is less than about 40%, and preferably is 10% to 30%, of a total size of the first white emission area (W-EA).

3. The display apparatus according to claim 1 or 2, wherein the blue color pattern (600B) includes a first blue pattern (610B) having a main extension in a second direction (Y) and a second blue pattern (620B) having a main extension in a first direction (X) different from the second direction (Y),
wherein a length (620w) of the second blue pattern (620B) in the second direction (Y) is smaller than a length of the first white emission area (W-EA) in the second direction (Y), and
wherein the first blue pattern (610B) overlaps an edge of the first white emission area (W-EA) in the first direction (X).

4. The display apparatus according to claim 3, wherein a width of the second blue pattern (620B) in the first direction (X) is different from a width (610w) of the first blue pattern (610B) in the first direction (X).

5. The display apparatus according to any one of the preceding claims, wherein an upper surface of the over-coat layer (150) toward the first white light-emitting device (300) includes a concave portion (151c) and a convex portion (152c), which overlap with the first white emission area (W-EA),
wherein the concave portion (151c) of the upper surface is disposed outside of the blue color pattern (600B), and
wherein the convex portion (152c) of the upper surface overlaps the blue color pattern (600B).

6. The display apparatus according to any one of the preceding claims, further comprising a second white light-emitting device (300) on a second white emission area (W-EA) of the device substrate (100),
wherein the over-coat layer (150) extends to the second white emission area (W-EA) of the device substrate (100) and the second white light-emitting device (300), and
wherein a portion of the over-coat layer (150) overlapping with the second white emission area (W-EA) has a constant thickness.

7. The display apparatus according to claim 6, wherein the second white emission area (W-EA) is disposed side by side with the first white emission area (W-EA) in the second direction (Y).

8. The display apparatus according to any one of the preceding claims, further comprising a blue color filter (500B) on a blue emission area (B-EA) of the device substrate (100),
wherein the blue color pattern (600B) includes a same material as the blue color filter (500B).

9. The display apparatus according to any one of the preceding claims, further comprising a red emission area (R-EA) or a green emission area (G-EA) of the device substrate (100) disposed to be adjacent to the first white emission area (W-EA) in a first direction (X),
wherein the blue color pattern (600B) includes a first blue pattern (610B) extending in a second direction (Y) different from the first direction (X) and overlapping an edge of the first white emission area (W-EA) toward the red emission area (R-EA) or the green emission area (G-EA).

10. The display apparatus according to any one of the preceding claims, comprising:
a first color filter (500G) on a first color emission area (G-EA) of the device substrate (100);
the over-coat layer (150) on the device substrate (100), the over-coat layer (150) covering the blue color pattern (600B) and the first color filter (500G); and
a light-emitting unit (320) on the over-coat layer (150), the light-emitting unit (320) overlapping with the first white emission area (W-EA) and the first color emission area (G-EA),
wherein the first color emission area (G-EA) is disposed side by side with the first white emission area (W-EA) in a first direction (X),
wherein the first color filter (500G) overlaps the entirety of the first color emission area (G-EA), and
wherein the blue color pattern (600B) overlaps only a portion of the first white emission area (W-EA).

11. The display apparatus according to any one of the preceding claims, wherein the blue color pattern (600B) includes a first blue pattern (610B) extending along an edge of the first white emission area (W-EA) and a second blue pattern (620B) spaced apart from the first blue pattern (610B).

12. The display apparatus according to claim 11, wherein a part of the white light generated by the first white emission area (W-EA) is emitted outside through a space between the first blue pattern (610B) and the second blue pattern (620B), and/or wherein the second blue pattern (620B) is surrounded by a portion of the first white emission area (W-EA) exposed by the blue color pattern (600B).

13. The display apparatus according to any one of claims 10 to 12 when dependent on claim 10, further comprising a second color filter (500B) on a second color emission area (B-EA) of the device substrate (100),
wherein the light-emitting unit (320) extends on the second color emission area (B-EA) disposed side by side with the first white emission area (W-EA) and the first color emission area (G-EA) in the first direction (X),
wherein the second color filter (500B) includes a different material from the first color filter (500G), and
wherein the blue color pattern (600B) includes a same material as the first color filter (500G) or the second color filter (500B).

14. The display apparatus according to claim 13, wherein the over-coat layer (150) includes an upper surface toward the light-emitting unit (320),
wherein the upper surface of the over-coat layer (150) overlapping with the second color emission area (B-EA) has a same shape as the upper surface of the over-coat layer (150) overlapping with the first color emission area (G-EA), and
wherein the upper surface of the over-coat layer (150) overlapping with the first white emission area (W-EA) has a different shape from the upper surface of the over-coat layer (150) overlapping with the second color emission area (B-EA).

15. The display apparatus according to any one of the preceding claims, wherein the light-emitting unit (320), or, respectively, a light-emitting unit (320) of the first white light-emitting device (300), includes:
a first emission stack (321) including a red emission material layer (321re),
a first charge generation layer (322),
a second emission stack (323) including a blue emission material layer (323be),
a second charge generation layer (324),
a third emission stack (325) including a green emission material layer (325ge),
a third charge generation layer (326), and
a fourth emission stack (327) including a blue emission material layer (327be).
